Europäisches Patentamt

European Patent Office

Office européen des brevets

(19)

(11) Publication number: **0 160 183**
**A2**

(12) **EUROPEAN PATENT APPLICATION**

(21) Application number: **85102631.0**

(22) Date of filing: **08.03.85**

(51) Int. Cl.⁴: **H 01 L 29/78**
**H 01 L 29/06**

(30) Priority: **03.05.84 US 606797**

(43) Date of publication of application:
**06.11.85 Bulletin 85/45**

(84) Designated Contracting States:
**DE GB NL**

(71) Applicant: **Rockwell International Corporation**
**2230 East Imperial Highway**
**El Segundo, California 90245(US)**

(72) Inventor: **Chow, Pei-Ming Daniel**
**3362 Keystone Avenue Apt. 9**
**Los Angeles California 90034(US)**

(74) Representative: **Wagner, Karl H. et al,**
**WAGNER & GEYER Patentanwälte**
**Gewuerzmuehlstrasse 5 Postfach 246**
**D-8000 München 22(DE)**

(54) **High voltage mos field effect transistor.**

(57) Briefly and in general terms the invention provides a high voltage MOS field effect transistor having a source and drain separated from each other by a deep n- well in the substrate of opposite conductivity.

EP 0 160 183 A2

PF82E82

# HIGH VOLTAGE MOS FIELD EFFECT TRANSISTOR

## BACKGROUND OF THE INVENTION

### Field of the Invention

The invention relates to semiconductor devices and methods of fabricating semiconductor devices, and more particularly to MOS field effect transistors capable of operating at high voltage.

### Description of the Prior Art

There are a number of prior art references concerned with high voltage structures in semiconductor devices, and the pertinent features are briefly noted and reviewed here.

Meguro USP 4,285,116 discloses a high voltage MIS device using a lightly doped shallow diffusion region to connect the drain and source to the channel region.

..The concept of a field shield electrode on an insulating layer overlying at least the PN junction of a drain region is shown in Chiu et al T964,009 (Defensive Publication).

Ronen USP 4,288,802 (Figure 10) discloses a high voltage MOSFET having a field plate 80 to bend lines away from the drain area, thereby increasing available breakdown adjacent the drain area. The device is laid out in concentric rings. ·

Deep wells in a high voltage MOS device are described in the IEEE Journal of Solid State Circuits article entitled "High-Voltage Simultaneous Diffusion Silicon-Gate CMOS", published in Volume SC-9, No. 3, June, 1974.

An off-set channel in a high voltage MOSFET is discussed in Electronics, December 6, 1971, page 41.

Field plates in an MOS are described generally in Masuda et al US Patent No. 4,132,997. In Sakamoto et al USP 3,909,306, a low impurity concentration well 8 is located under drain 10 in a high voltage MIS device.

SUMMARY OF THE INVENTION

Briefly and in general terms the invention provides a high voltage MOS field effect transistor having a source and drain separated from each other by a deep n- well in the substrate of opposite conductivity,

PF82E82

- 3 -

conductor with a distance between the drain and gate being relatively large. This n-well drift region is formed the same time as other n-wells where the p-channel devices reside in a n-well CMOS process. The metal which connects the source contact extends and overlaps the polygate region to form a field plate, reducing the electric field in the drift region. A preferred embodiment of the present invention has the structure implemented in a circular or elliptical format to avoid sharp corners.

The novel features which are considered as characteristic for the invention are set forth in particular in the appended claims. The invention itself, however, both as to its construction and its method of operation, together with additional objects and advantages thereof will be best understood from the following description of specific embodiments when read in connection with the accompanying drawings.

BRIEF DESCRIPTION OF THE DRAWING

Figure 1 shows a highly simplified cross-sectional view of the high voltage MOS field effect transistor according to the present invention;

Figure 2 shows a top plan view of a first embodiment of an implementation of the present invention on a semiconductor substrate; and

Figure 3 shows a top plan view of the shaded portion of the first embodiment of Figure 3 of an implementation of the present invention on a semiconductor substrate;

PF82E82

- 4 -

Figure 4 is a cross sectional view of the high voltage MOS field effect transistor according to the present invention together with low voltage n-channel and p-channel transistors.

## DESCRIPTION OF THE PREFERRED EMBODIMENTS

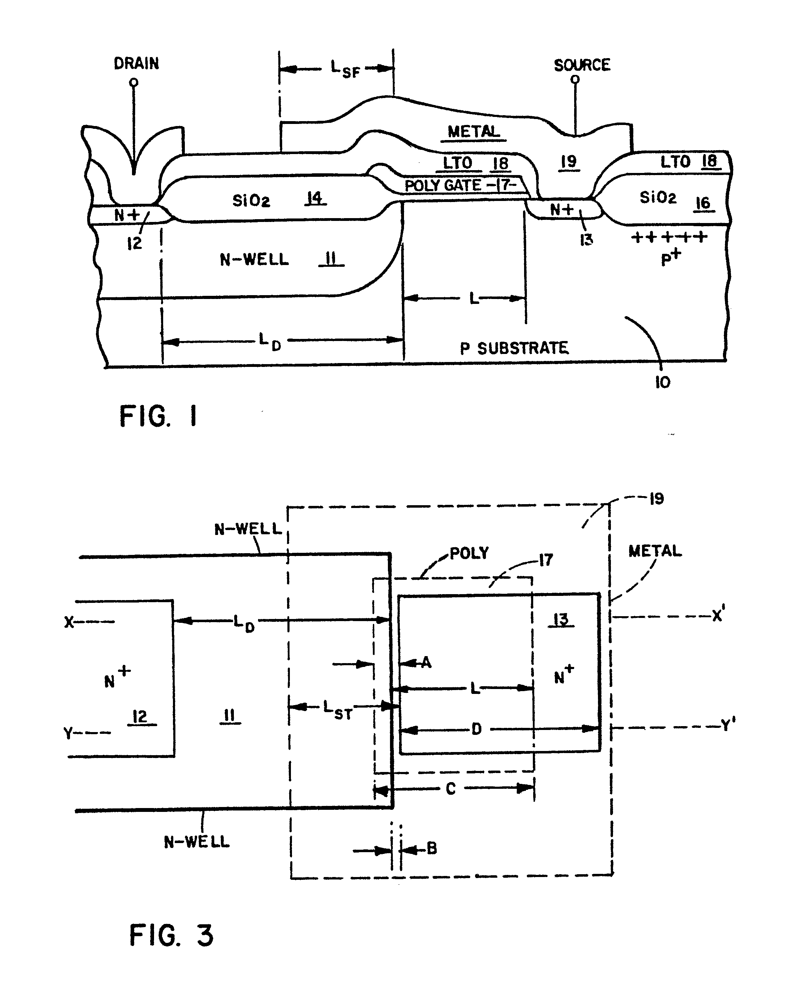

Turning first to Figure 1, there is shown the cross-section of the high voltage transistor with the low voltage CMOS logic devices. A 9-layer silicon gate LOCOS type n-well CMOS process is used throughout our description for the fabrication of the device structures. The high voltage MOS device is n-channel and has an enclosed drain structure with metal field plate extending from the source node. The drain region is composed of a shallow n+ region made from the source/drain arsenic implant and a 6-μm deep phosphorus doped n-well drift region under the field oxide. This n-well drift region is formed by the same processing steps as other n-wells where the p-channel devices reside in the n-well CMOS process. The devices are fabricated on $\langle 100 \rangle$, 15-25 $\Omega$ -cm p-type silicon. The high voltage MOSFET has the same threshold voltage as the low voltage n-channel device.

The device is constructed on a p-type substrate 10 in which an n-well 11 is provided by means of diffusion or ion implantation according to techniques known in the art. An n+ drain region 12 is provided in the n-well 11, and an n+ source 13 is provided in the p type substrate 10 for forming the source. Both 12 and 13 regions are formed by ion implantation. A thick silicon dioxide region 14 is provided on the surface of the n-well 11 and extends into a much thinner oxide region 15

PF82E82

- 5 -

which is provided along the surface of the p type substrate between n-well 11 and the source region 13 and forms the gate oxide of the high voltage MOS device. Another thick field silicon dioxide region 16 is provided adjacent the n+ contact 13 to isolate the structure formed from other devices in the circuit to be constructed according to the present invention. The regions 14 and 16 are formed in the same oxidation cycle.

A gate region 17 consisting of thin film polysilicon is deposited over the thin gate oxide 15 to form the polysilicon gate of the MOS field effect transistor formed according to the present invention. A low temperature oxide (LTO) layer 18 is then deposited over the silicon dioxide region 14 and the polysilicon gate 17 for electrically isolating such regions from the metal source contact. The metal source contact 19 is provided over the dielectric region 18 making contact with the n+ source 13 and extending over the gate polysilicon region 17 as well as a portion over the silicon dioxide region 14 and the n-well 11.

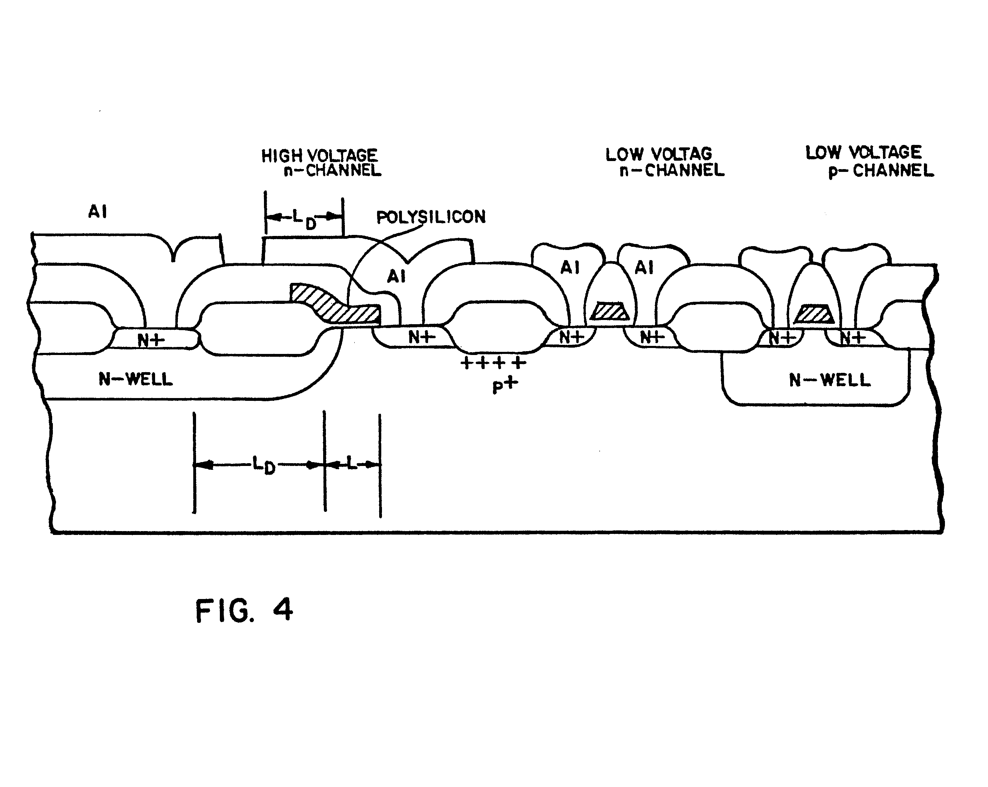

Turning next to Figure 3, there is a shown a detailed top plan view of the embodiment of a portion of (between the x-x and y-y lines) the invention shown in Figure 1. In particular, there is shown the drain contact 12 and the source contact 13 regions. The n-well 11 extending adjacent to the n+ region 13 and separated therefrom by a distance labelled B in the figure. The distance between the n+ region 12 and the n+ region 13 is labelled $L_D$ in the figure. A polysilicon gate 17 is shown extending over portions of the n-well 11 as well as the n+ region 13. The polysilicon gate extends a distance A beyond the edge of the n+ region 13. The metal region 19 extends a distance $L_{ST}$ beyond the edge of the n+ region 13. The width of the polysilicon gate 17 is C and the width of the n+ region 13 is D.

PF82E82

- 6 -

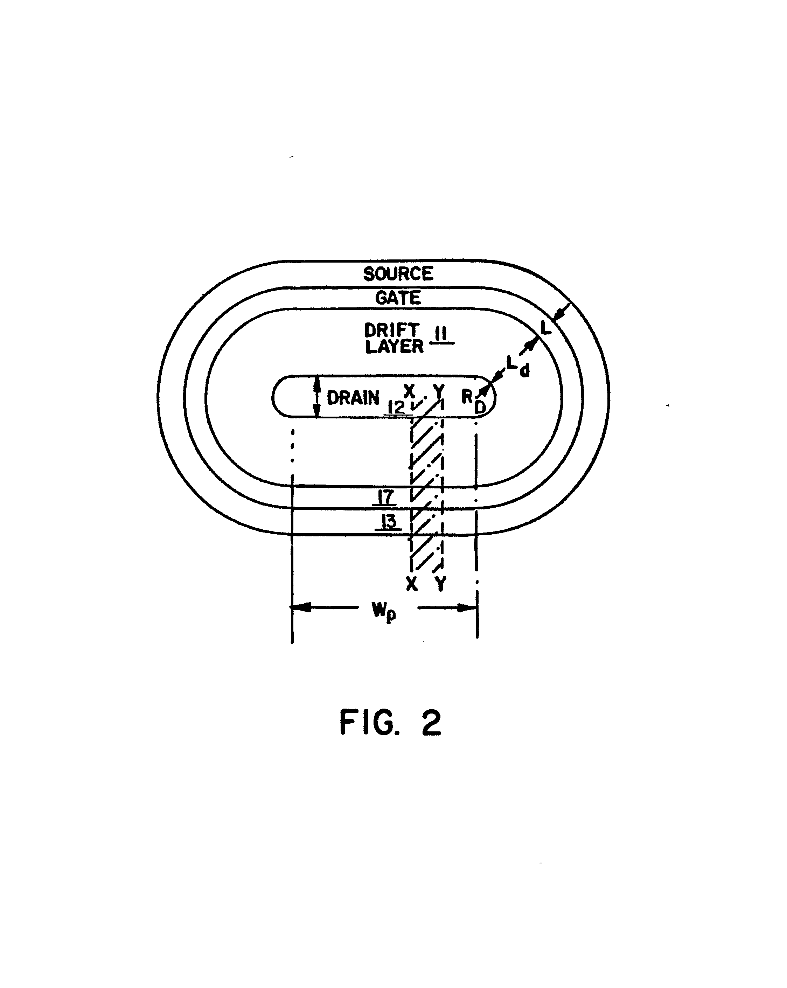

Turning next to Figure 2, there is shown a detailed top plan view of a first embodiment of an implementation of the present invention in which the invention has been laid out in circular or elliptical form. The drain 12 is shown to be in the middle surrounded by drift layer $L_D$ corresponding to the $L_D$ in Figure 3. The gate region 17 is then concentric with both the drain and the drift layer and has a width of L. The source is then concentric around the drain, drift layer and gate.

Figure 4 is a cross-sectional view of the high voltage MOS field effect transistor integrated with both low voltage n channel and p channel transistors and are fabricated from the same process sequence. The left hand portion of the figure shows the high voltage n channel MOS transistor essentially as shown in Figure 1. The middle of the figure shows a low voltage n channel MOS transistor and the right hand portion of the figure shows a low voltage p channel MOS transistor. These n-channel and p-channel devices are used in the normal CMOS logic circuit. The high voltage MOS device can be used in the output driver stage.

While the invention has been illustrated and described as embodied in a High Voltage MOS Field Effect Transistor, it is not intended to be limited to the details shown, since various modifications and structural changes may be made without departing in any way from the spirit of the present invention.

It will be obvious to those skilled in the art that the semiconductor device according to the present invention can be implemented with various semiconductor technologies and different combinations of known process steps, and that the preferred embodiments illustrated here are merely exemplary. The depth of penetration of the various zones and regions and in particular the configuration and distance between the active zones of the transistor devices, as well as the concentrations of dopant species, and/or their concentration profiles, can be chosen depending upon the desired properties. These and other variations can be further elaborated by those skilled in the art without departing from the scope of the present invention.

The present invention is moreover not restricted to the particular embodiments of the high voltage MOSFET described. For example, it may be pointed out that semiconductor materials other than silicon, for example, $A_{III}-B_V$ compounds may be used. Furthermore, the conductivity types in the embodiment may be interchanged and corresponding to such change, the polarity of the respective operating voltages adapted. Moreover, the voltage level and the static or dynamic nature of the signals applied to the various terminals and gates of the device, as well as the voltage sources, may be suitably selected as desired for a particular application. Other types of semiconductor circuits including bipolar junction field effect transistor, MNOS (metal electrode-silicon nitride, silicon oxide-semiconductor), MAOS (metal, aluminum oxide, silicon oxide, semiconductor), MAS (metal, aluminum oxide, semiconductor), floating gate FETs, and AMOS FETs (avalanche MOS FETs), may be used as well.

PF82E82

- 8 -

Without further analysis, the foregoing will so fully reveal the gist of the present invention that others can, by applying current knowledge, readily adapt it for various applications without omitting features that, from the standpoint of prior art, fairly constitutes essential characteristics of the generic or specific aspects of this invention, and, therefore, such adaptations should and are intended to be comprehended within the meaning and range of equivalence of the following claims.

What is claimed is:

Claims

1.    A high voltage MOS transistor comprising;

a substrate of first conductivity type and having a first doping concentration;

a first region of semiconductor material of second conductivity type and a second dopant concentration on the surface of said substrate;

a third semiconductor region of said second conductivity type and a third dopant concentration much higher than said first and second dopant concentration disposed in said second semiconductor region on said major surface of said body, the periphery of said third semiconductor region being surrounded on the major surface of said body by said second semiconductor region;

a thin fourth semiconductor region of second conductivity type and third dopant concentration and spaced apart from said second and said third semiconductor regions;

a thin dielectric layer on the surface of said body extending between said third semiconductor region and said fourth semiconductor region;

a thin dielectric layer on the surface of said second semiconductor region;

a gate electrode disposed on said dielectric layer extending between said second semiconductor region and said fourth semiconductor region;

Claim 1 (Continued)

an insulating layer covering said gate electrode and the said tick dielectric layer;

a conducting layer disposed on said insulating layer including a portion disposed over said first dielectric layer and a portion of the said thick dielectric region for acting as a field plate and reducing the electrical field in the said second semiconductor region and a second portion making physical and electrical contact with said fourth semiconductor region.

2. A semiconductor device as defined in Claim 1 wherein the shape of said drain region is in the form of an elongated ellipse.

3. A semiconductor device as defined in Claim 1 wherein the shape of said drain region is in the form of a circle.

782M

DRAIN

SOURCE

$L_{SF}$

METAL

LTO  18

19

LTO  18

SiO₂  14

POLY GATE -17-

SiO₂  16

N+

N+

N-WELL  11

12

13

++++++
P⁺

L

$L_D$

P SUBSTRATE

10

**FIG. 1**

19

N-WELL

POLY  17

METAL

N-WELL

X ---

$L_D$

13

X'

N⁺

A

N⁺

L

Y ---

12

11

$L_{ST}$

D

Y'

C

N-WELL

B

**FIG. 3**

FIG. 2

FIG. 4